# FASCICULE DE BREVET EUROPEEN

(11) **EP 0 812 042 B1**
(45) Date de publication et mention de la délivrance du brevet: **21.10.2009**
(21) Numéro de dépôt: 97401217.1
(22) Date de dépôt: 02.06.1997
(51) Int. Cl.: H01S 5/34, G02B 6/12, G02B 6/30

(54) **Dispositif optique à guide de lumière semiconducteur, à faisceau émergent de faible divergence, application aux lasers de Fabry-Pérot et à contre-réaction distribuée**
Optische Halbleiterwellenleitervorrichtung mit niedriger Divergenz und Verwendung in einem Fabry-Perot- oder DFB-Laser
Optical waveguide semiconducting device having a reduced far-field, and its application to fabry-perot and DFB lasers

(30) Priorité: 04.06.1996 FR 9606877
(43) Date de publication de la demande: 10.12.1997
(73) Titulaire: Avanex Corporation, Fremont, CA 94538 (US)
(72) Inventeur: Ougazzaden, Abdallah, 92260 Fontenay aux Roses (FR); Bouadma, Noureddine, 94250 Gentilly (FR); Kazmierski, Christophe, 91420 Morangis (FR)
(74) Mandataire: Feray, Valérie

(56) Documents cités:
- EP-A- 0 578 836
- PATENT ABSTRACTS OF JAPAN vol. 011, no. 011 (E-470), 13 janvier 1987 & JP 61 184895 A (MITSUBISHI ELECTRIC CORP), 18 août 1986,
- PATENT ABSTRACTS OF JAPAN vol. 009, no. 310 (E-364), 6 décembre 1985 & JP 60 145687 A (NIPPON DENKI KK), 1 août 1985,
- PATENT ABSTRACTS OF JAPAN vol. 013, no. 144 (E-740), 10 avril 1989 & JP 63 306686 A (OKI ELECTRIC IND CO LTD), 14 décembre 1988,
- OUGAZZADEN A ET AL: "HIGH TEMPERATURE CHARACTERISTIC TO AND LOW THRESHOLD CURRENT DENSITY OF 1.3UM INASP/INGAP/INP COMPENSATED STRAIN MULTIQUANTUM WELL STRUCTURE LASERS" ELECTRONICS LETTERS, vol. 31, no. 10, 11 mai 1995, pages 803-805, XP000518299
- LI G P ET AL: "1.55UM INDEX/GAIN COUPLED DFB LASERS WITH STRAINED LAYER MULTIQUANTUM-WELL ACTIVE GRATING" ELECTRONICS LETTERS, vol. 28, no. 18, 27 août 1992, pages 1726-1727, XP000309478

## Description

### DOMAINE TECHNIQUE

La présente invention concerne un dispositif optique à guide de lumière semiconducteur, à faisceau émergent de faible divergence.

Elle s'applique notamment au domaine des télécommunications optiques et, plus particulièrement, aux transmissions par fibre optique à 1,3 µm et 1,5 µm pour des applications de distribution de services chez les abonnés.

Pour généraliser ce type de liaison optique, il est impératif de diminuer le coût des composants optoélectroniques d'extrémité en respectant des exigences de haute performance, de robustesse et de stabilité dans la gamme de températures allant de -40°C à +85°C.

Une part importante du coût provient des opérations d'assemblage et de fibrage, qui, pour l'instant restent des opérations individuelles.

Un composant d'extrémité (tête optique) comprend essentiellement une puce (comportant par exemple un laser amplificateur, un modulateur ou un détecteur) et une fibre qui doit être alignée et fixée en face de la partie active de la puce ("*chip*").

Dans le cas particulier du laser, avec une divergence typique du faisceau de 30° à 40°, cette opération exige une précision sub-micronique de positionnement de la fibre pour obtenir le taux optimal de couplage de la puissance optique dans la fibre et, par conséquent, les meilleures performances du composant.

Cette précision implique des techniques de montage et de fibrage complexes et coûteuses, consommatrices de temps et ne se prêtant pas au traitement collectif.

### ÉTAT DE LA TECHNIQUE ANTÉRIEURE

Il est connu qu'une efficacité de couplage optimale et une grande tolérance d'alignement d'un dispositif à guide semiconducteur (par exemple un laser semiconducteur) avec une fibre optique sont obtenues lorsque la divergence du mode du dispositif est faible et proche de celle du mode de la fibre optique.

Or, les modes guidés d'un composant à guide semiconducteur standard sont généralement elliptiques et de petite taille (de l'ordre de 1 µm à 2 µm), ce qui est équivalent à une forte divergence.

Par contre, les fibres optiques monomodes utilisées pour les télécommunications optiques transportent des modes circulaires gaussiens dont le diamètre est d'une dizaine de microns (par exemple, 8 µm pour une fibre à dispersion décalée de type G653).

Par conséquent, il faut qu'au moins l'un des deux modes soit adapté et acquière la taille et la divergence de l'autre.

L'utilisation d'une fibre dont l'extrémité est pourvue d'une lentille diminue la taille du mode et augmente sa divergence du côté de la fibre (de l'ordre de 2 µm à 3 µm) et permet d'augmenter le taux de couplage mais ne diminue pas les tolérances d'alignement.

Une solution plus efficace, mais techniquement plus difficile à mettre en oeuvre, à cause de l'indice de réfraction élevé, consiste à augmenter la taille du mode du côté du dispositif semiconducteur.

On connaît déjà, par les documents (1) à (9) qui, comme les autres documents cités par la suite, sont mentionnés à la fin de la présente description et auxquels on se reportera, plusieurs dispositifs lasers et amplificateurs semiconducteurs à divergence réduite.

Tous ces dispositifs connus sont fondés sur l'intégration d'un guide semiconducteur ordinaire (laser, amplificateur, modulateur par exemple) avec une section à guide différent (amplificateur ou passif) dans lequel le mode guide est progressivement dilaté.

Cette dilatation est obtenue soit par réduction progressive de la largeur du ruban ("stripe") que comporte le guide jusqu'à l'obtention d'une pointe de dimensions subs-microniques, soit par réduction de l'épaisseur de ce ruban selon un profil continu ou un profil en marches d'escalier.

La réduction progressive des dimensions latérales et/ou verticales du ruban provoque une diminution de l'indice effectif du guide et un déconfinement progressif du mode, déconfinement qui est équivalent à une faible divergence du faisceau susceptible d'être émis par le guide.

Les performances des dispositifs avec adaptateurs de mode intégrés varient selon la complexité de leurs structures.

Par exemple, dans certaines structures (voir les documents (1) à (5)), on remarque la présence d'un guide passif ayant une largeur de l'ordre de 6 à 8 µm, situé au dessous du ruban actif que comprennent ces structures.

Le mode se propageant dans le ruban actif est ainsi progressivement couplé dans ce guide par évanescence de telle manière que la largeur du mode à la sortie du composant soit déterminée par les dimensions du guide passif.

Les plus faibles divergences parallèlement
ou perpendiculairement aux couches actives (planes) que comprennent de tels composants intégrés varient entre 6° et 10°.

Les plus faibles valeurs des pertes de couplage dans une fibre dont l'extrémité est pourvue d'une lentille sont de l'ordre de 2 à 3 dB.

Afin d'éviter la complexité des structures intégrées, une autre solution a été proposée tout récemment.

Elle est expliquée dans le document (10).

Elle concerne un laser à ruban actif enterré de largeur constante et très faible (de l'ordre de 0,4 µm).

Cette largeur est optimisée pour réaliser le meilleur compromis entre la réduction de la divergence due au faible confinement du mode et la perte de performance liée à la réduction du gain modal dans ce laser.

Avec le guide de très faible largeur, qui est décrit dans le document (10), on remédie à certains inconvénients, comme la longueur du dispositif et les pertes supplémentaires, et l'on a la possibilité de fabriquer des lasers à contre-réaction distribuée ("*distributed feed-back lasers*")*,* ou lasers DFB, performants.

Cependant, la réduction de la largeur du ruban (à des valeurs aussi faibles que 0,4 µm) conduit nécessairement à une diminution des performances des dispositifs actifs.

Par ailleurs, non seulement les dimensions sub-microniques du ruban optimisé sont à la limite du contrôle technologique mais aussi, pour un guide si étroit, les caractéristiques du composant deviennent moins tolérantes aux variations géométriques.

L'analyse des dispositifs optiques semiconducteurs connus, qui comprennent un guide de lumière, ont une divergence réduite et utilisent un adaptateur de mode intégré, montre que ces dispositifs présentent de nombreux inconvénients.

Par rapport aux dispositifs à une seule fonction (laser, amplification, modulation par exemple), l'ajout de l'adaptateur de mode nécessite l'utilisation d'une technique de fabrication plus complexe avec des étapes supplémentaires de croissance épitaxiale (au total 4 à 5 étapes) et de gravure de ruban submicrométrique (souvent par écriture directe coûteuse avec un masqueur électronique).

Ceci a des conséquences sur le rendement de fabrication et donc sur le coût des dispositifs.

En particulier, les tolérances géométriques des adaptateurs modaux sont souvent à la limite des possibilités technologiques, ce qui diminue la maîtrise et la reproductibilité du diagramme d'émission.

De plus, l'addition d'une zone de transition engendre généralement une dégradation des performances des composants telle qu'une augmentation des courants de fonctionnement, une baisse de la puissance, de l'amplification et de l'absorption, un faisceau optique émis perturbé présentant des lobes secondaires qui entourent le lobe principal.

En outre, pour assurer une dilatation du mode guidé aussi douce que possible (transformation adiabatique), la zone de transition doit présenter une longueur (de l'ordre de 200 à 400 µm), ce qui introduit des pertes de propagation supplémentaires et rallonge la longueur totale du dispositif à des valeurs excessives (de l'ordre de 600 à 800 µm), réduisant ainsi le rendement de fabrication sur une plaque ("*wafer*") semiconductrice de 2 pouces (environ 5 cm).

Par ailleurs, dans le cas particulier des lasers DFB, la zone de transition induit des perturbations importantes dans la distribution longitudinale des porteurs de charge injectés (phénomène connu sous le nom de "*hole burning*"), perturbations qui se traduisent par une dégradation du comportement spectral et dynamique de ces lasers.

### EXPOSÉ DE L'INVENTION

La présente invention a pour but de remédier aux inconvénients précédents, en proposant un dispositif optique à guide de lumière semiconducteur dans lequel le coeur du guide comprend :
- au moins une couche dont l'indice de réfraction est élevé et fixé par la nature du dispositif (qui peut être un laser, un amplificateur de lumière, un modulateur de lumière ou même un simple dispositif de guidage de lumière), et
- au moins une couche à faible indice de réfraction, ce dernier étant inférieur à l'indice de réfraction de chaque couche de confinement ("*cladding layer*") du guide ou voisin de celui-ci.

Dans la présente invention, la largeur du coeur du guide est arbitraire.

De plus, le dispositif objet de l'invention est réalisable de façon simple, par des techniques classiques JP61184895 (Mitsubishi Electric Corp) décrit un laser semi-conducteur comprenant une couche active (coeur) et, de part et d'autre de celle-ci , des multicouches en super-réseaux d'indice plus faible que celui du coeur. EP0578836 (Mitsui petrochemical Ind) décrit un laser semi-conducteur comprenant une couche active (coeur) et, de part et d'autre de celle-ci, des couches de faible indice.

De façon précise, la présente invention a pour objet un dispositif, à guide de lumière semiconducteur selon la revendication 1, ce dispositif étant apte à fournir un faisceau lumineux de faible divergence, le guide de lumière comprenant un coeur et des couches de confinement entre lesquelles se trouve le coeur, ce dispositif étant **caractérisé en ce que** le coeur du guide comprend un ensemble de couches semiconductrices.

Grâce à la présente invention, le faisceau lumineux émergeant du dispositif a une faible divergence qui est inférieure à 20° dans deux directions : l'une parallèle aux couches et l'autre perpendiculaire à celles-ci.

Par "indice de réfraction voisin de celui d'une couche de confinement", on entend un indice de réfraction égal à celui de cette couche de confinement
ou légèrement supérieur, de quelques % et en tout cas de moins de 5% environ, à ce dernier.

Le dispositif objet de l'invention peut comprendre une pluralité de premières couches semiconductrices et une pluralité de deuxièmes couches semiconductrices qui alternent avec les premières couches semiconductrices.

Dans le dispositif objet de l'invention, le coeur du guide peut comprendre en outre des troisièmes couches semiconductrices dont l'indice de réfraction est inférieur à l'indice de réfraction de chaque première couche semiconductrice et supérieur à l'indice de réfraction de chaque deuxième couche semiconductrice.

Dans un premier mode de réalisation particulier, le coeur du guide comprend deux troisièmes couches semiconductrices qui sont placées de part et d'autre dudit ensemble de couches.

Dans un deuxième mode de réalisation particulier, le coeur du guide comprend une pluralité de troisièmes couches semiconductrices, chaque troisième couche semiconductrice étant comprise entre une première couche semiconductrice et une deuxième couche semiconductrice.

Le coeur du guide du dispositif objet de l'invention peut être optiquement inactif, ce qui correspond à un dispositif optique passif, par exemple un dispositif de guidage de lumière.

Au contraire, le coeur du guide peut être optiquement actif (et peut avoir, dans ce cas, la forme d'un ruban), ce qui correspond à un dispositif optique actif comme par exemple un laser.

Dans ce cas, le coeur du guide peut avoir une structure de multipuits quantiques à contraintes compensées ("*compensated strain multiquantum well structure*") et comprendre des couches de puits contraintes en tension (respectivement en compression), qui sont choisies pour constituer lesdites premières couches semiconductrices, et des couches de barrières contraintes en compression (respectivement en tension), qui sont choisies pour constituer lesdites deuxièmes couches semiconductrices et sont aptes à compenser les contraintes des couches de puits.

La présente invention s'applique en particulier aux lasers de Fabry-Pérot qui comprennent une zone active, cette zone active étant alors formée par le coeur du guide constitué comme on l'a expliqué plus haut.

L'invention s'applique également aux lasers à contre-réaction distribuée comprenant une zone active munie d'un réseau de diffraction de Bragg, cette zone active étant alors formée par le coeur du guide constitué comme on l'a expliqué plus haut.

La présente invention permet d'obtenir un dispositif à guide semiconducteur apte à fournir un faisceau lumineux dont la divergence est faible, sans avoir les inconvénients des dispositifs connus, mentionnés plus haut, permettant une réduction de cette divergence.

Dans l'invention, cette réduction de la divergence est obtenue sans intégration d'adaptateur de mode et grâce à des techniques classiques de fabrication comme par exemple les techniques classiques de fabrication de lasers, d'amplificateurs de lumière, de modulateurs de lumière ou de guides enterrés (par exemple les lasers à ruban enterré).

Dans un dispositif conforme à l'invention, l'indice de réfraction moyen du coeur du guide peut être ajusté en choisissant les volumes respectifs des matériaux constitutifs des couches à fort indice de réfraction (premières couches semiconductrices) et des couches à faible indice de réfraction (deuxièmes couches semiconductrices).

En particulier, pour une structure de coeur correspondant à un faible indice de réfraction moyen, l'indice effectif du guide peut être diminué, ce qui provoque un confinement faible du mode et une diminution de la divergence du faisceau émergeant du dispositif.

Une perte d'un effet modal (absorption/gain/indice par exemple) d'un dispositif actif peut être compensée, selon la présente invention, par l'augmentation du volume global du coeur avec des couches à fort indice et des couches à faible indice.

Un dispositif conforme à l'invention permet d'obtenir une divergence de faisceau ne dépassant pas 10 à 15° environ, dans les deux directions perpendiculaires, sans utilisation d'une zone d'adaptation de mode et en utilisant des techniques classiques de réalisation de lasers ou d'amplificateurs à double-hétérostructure comme la technologie BRS (deux étapes d'épitaxie, une étape de photolithographie standard et une gravure chimique ou une gravure sèche pour délimiter un ruban actif ayant des dimensions latérales et verticales constantes).

Un tel dispositif possède un ruban, a priori large, permettant d'augmenter les tolérances géométriques.

En particulier, il est bien adapté aux lasers à contre-réaction distribuée à divergence réduite grâce à la possibilité de conserver un ruban de largeur fixe dans tout le dispositif.

Cependant, l'invention n'exclut pas que l'on puisse faire varier les dimensions géométriques du ruban, si cela est nécessaire (par exemple par l'ajout d'un adaptateur modal), ce qui permet d'avoir des tolérances de fabrication plus larges que celles des dispositifs connus, mentionnés plus haut.

La fabrication du dispositif objet de l'invention est particulièrement adaptée à l'utilisation des matériaux de coeur distribués, comme par exemple les matériaux à puits quantiques ("*quantum well materials*") les plus souvent utilisés dans les dispositifs opto-électroniques avec des guides en matériaux semiconducteurs III-V.

### BRÈVE DESCRIPTION DES DESSINS

La présente invention sera mieux comprise à la lecture de la description d'exemples de réalisation donné ci-après, à titre purement indicatif et nullement limitatif, en faisant référence aux dessins annexés sur lesquels :
- les figures 1 et 2 montrent les variations de l'indice de réfraction dans des dispositifs optiques à guides de lumière semiconducteurs classiques,
- la figure 3 représente les variations de l'indice de réfraction dans un dispositif optique à guide de lumière semiconducteur conforme à l'invention,
- la figure 4 représente les variations de l'indice de réfraction dans un autre dispositif conforme à l'invention, dans lequel le coeur du guide comprend des couches intermédiaires de part et d'autre d'un ensemble de couches qui ont un indice de réfraction élevé et qui alternent avec des couches à faible indice de réfraction,
- la figure 5 représente les variations de l'indice de réfraction dans un autre dispositif conforme à l'invention, dans lequel le coeur du guide comprend des couches intermédiaires comprises chacune entre une couche ayant un indice de réfraction élevé et une couche ayant un indice de réfraction faible,
- la figure 6 est une vue en coupe transversale schématique d'un autre dispositif conforme à l'invention, qui constitue un laser de Fabry-Pérot et dont le coeur a une structure de multipuits quantiques à contraintes compensées,
- la figure 7 est une vue en coupe transversale schématique et partielle du coeur du guide du dispositif de la figure 6, et
- la figure 8 est une vue en coupe longitudinale schématique et partielle d'un autre dispositif conforme à l'invention, qui constitue un laser à contre-réaction distribuée et dont le coeur a une structure de multipuits quantiques ("*multiquantum well structure*")*.*

### EXPOSÉ DÉTAILLÉ DE MODES DE RÉALISATION PARTICULIERS

Pour réduire la divergence d'émission d'an dispositif optique à guide de lumière semiconducteur, il est nécessaire d'augmenter la taille du mode guidé.

Ceci peut être accompli par réduction du confinement optique de ce guide.

L'un des moyens permettant cette réduction est la diminution de la différence d'indice réfraction entre le coeur du guide (qui peut être un ruban actif comme par exemple dans un laser à ruban enterré) et les couches de confinement qui entourent ce coeur.

Ceci peut être obtenu par utilisation d'un guide dont le coeur est constitué d'un ou de plusieurs matériaux ayant un faible indice de réfraction.

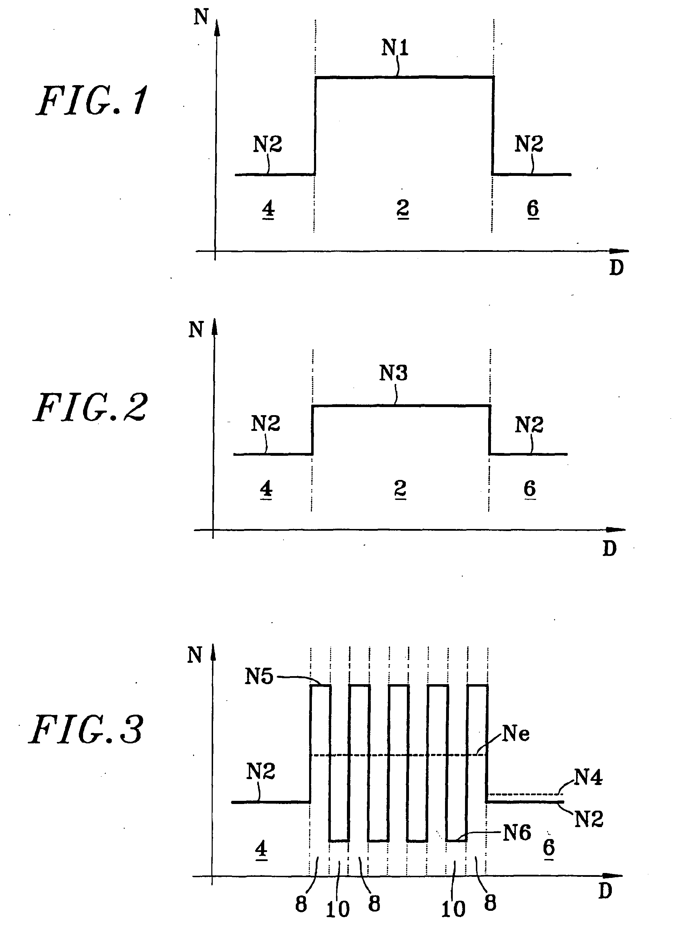

Ceci est schématiquement illustré par les figures 1 et 2 où l'on voit les variations de l'indice de réfraction N en fonction de la distance D, dans des dispositifs à guide de lumière connus.

La figure 1 montre schématiquement un dispositif à guide classique comprenant un coeur 2 en matériau semiconducteur, compris entre deux couches de confinement semiconductrices 4 et 6.

L'indice de réfraction N1 du coeur 2 est supérieur à l'indice de réfraction N2 des couches de confinement 4 et 6.

Sur la figure 1 comme sur les figures 2 à 5, la distance D est comptée suivant un axe perpendiculaire aux différentes couches du guide (couche(s) du coeur et couches de confinement).

La figure 2 montre de façon schématique un dispositif à guide de lumière connu, à faible divergence, dans lequel le coeur 2 a un indice de réfraction N3 inférieur à N1 (mais bien entendu supérieur à N2).

Comme on l'a vu, afin de conserver la fonction du dispositif optique, fonction qui impose l'indice de réfraction de chaque matériau du coeur du guide de ce dispositif (ce coeur peut être composé d'un seul matériau ou d'une pluralité de matériaux), la présente invention propose d'utiliser une ou une pluralité de couches que l'on peut appeler "couches intercalaires" et dont l'indice de réfraction est inférieur à l'indice de réfraction de chaque couche de confinement ou est voisin de ce dernier.

L'indice de réfraction moyen du coeur, selon l'invention, est ajustable par le choix des volumes respectifs des couches de coeur à fort indice de réfraction (supérieur à l'indice de réfraction de chaque couche de confinement) et des couches à faible indice de réfraction (couches intercalaires).

De plus, des matériaux d'indice de réfraction intermédiaire, connus dans l'état de la technique (comme par exemple les matériaux pour couches de confinement séparé ou les matériaux pour barrières de puits quantiques), peuvent également être utilisés dans l'invention pour affiner la valeur de l'indice de réfraction moyen du coeur, si cela est nécessaire.

Tout ceci est schématiquement illustré sur les figures 3 à 5.

La figure 3 montre de façon schématique et partielle un dispositif conforme à l'invention dont le coeur est entouré des couches de confinement 4 et 6 ayant le même indice de réfraction N2.

Cependant, l'une des couches de confinement, par exemple la couche référencée 6, pourrait avoir un indice de réfraction N4 différent de N2.

Le coeur du dispositif de la figure 3 comprend des couches semiconductrices 8 à fort indice de réfraction N5 (supérieur à l'indice de chaque couche de confinement) et, conformément à l'invention, des couches semiconductrices 10 à faible indice de réfraction N6 (inférieur à N5).

L'indice N6 de ces couches 10 est inférieur à l'indice de chaque couche de confinement.

Dans un autre mode de réalisation non représenté, N6 est sensiblement égal à N2 ou très légèrement supérieur à N2 mais ne dépassant pas 1,05xN2 environ.

Les couches 10 alternent avec les couches 8, comme on le voit sur la figure 3.

On obtient ainsi pour le coeur du dispositif de la figure 3 un indice de réfraction équivalent Ne compris entre N2 et N5.

Dans un mode de réalisation non representé le coeur comprend une seule couche de fort indice de réfraction et une seule couche de faible indice de réfraction, ou une seule couche de fort indice de réfraction entourée de deux couches de faible indice de réfraction.

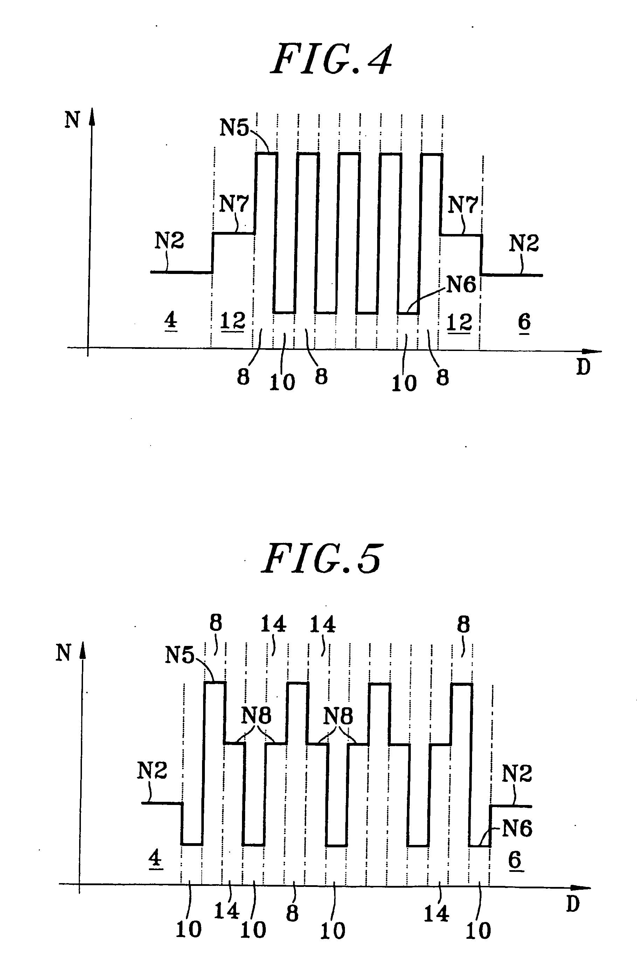

La figure 4 illustre de façon schématique et partielle un autre dispositif conforme à l'invention qui diffère simplement de celui de la figure 3 par le fait que l'ensemble des couches 8 et 10 qui alternent est entouré par deux couches semiconductrices intermédiaires 12 dont l'indice de réfraction N7 est supérieur à N6 et inférieur à N5.

La figure 5 illustre de façon schématique et partielle un autre dispositif conforme à l'invention dont le coeur comprend encore une alternance de couches 8 de fort indice de réfraction et de couches 10 de faible indice de réfraction ainsi que des couches semiconductrices intermédiaires 14 dont l'indice de réfraction 14 est compris entre N6 et N5, chaque couche intermédiaire 14 étant comprise entre deux couches 8 et 10 adjacentes.

Dans un mode de réalisation particulier de l'invention, le nombre de couches à fort indice du coeur est ajusté en fonction de la caractéristique modale (gain, absorption, changement d'indice par exemple) souhaitée pour le dispositif et le nombre de couches à faible indice de réfraction du coeur est choisi de façon à obtenir un faible indice de réfraction moyen pour le coeur du guide.

Un dispositif laser conforme à l'invention est par exemple réalisable avec un matériau de coeur constitué de multipuits quantiques à contraintes compensées.

Les couches de puits du coeur sont par exemple en un alliage InAsP contraint en compression, d'indice de réfraction de l'ordre de 3,5.

La valeur de la contrainte et l'épaisseur des couches de puits du coeur dépendent de la longueur d'onde d'émission choisie pour le laser.

Les couches de barrières sont en un alliage InGaP contraint en tension, d'indice de réfraction de l'ordre de 3,18 à la longueur d'onde 1,3 µm.

Cet indice des couches de barrières est légèrement inférieur à l'indice des couches de confinement du guide du dispositif, qui sont en InP d'indice de réfraction égal à 3,20.

L'épaisseur des couches de barrière et la contrainte de celles-ci sont optimisées pour compenser la contrainte des couches de puits.

Le nombre de puits et le nombre de barrières est également optimisé pour permettre un confinement vertical de la lumière qui soit faible mais suffisant pour guider le mode sans dégrader les performances du laser (faible courant de seuil, rendement quantique élevé, fonctionnement monomode).

Un tel agencement de couches permet non seulement d'obtenir une faible divergence d'émission conformément à la présente invention, mais encore d'empêcher les fuites des porteurs de charge hors des puits (voir le document (12)), ces fuites étant la cause principale de la dégradation des performances des lasers fonctionnant à haute température.

Bien entendu, on pourrait aussi utiliser une structure à multipuits quantiques à contraintes compensées, à couches de puits contraintes en tension et à couches de barrières contraintes en compression.

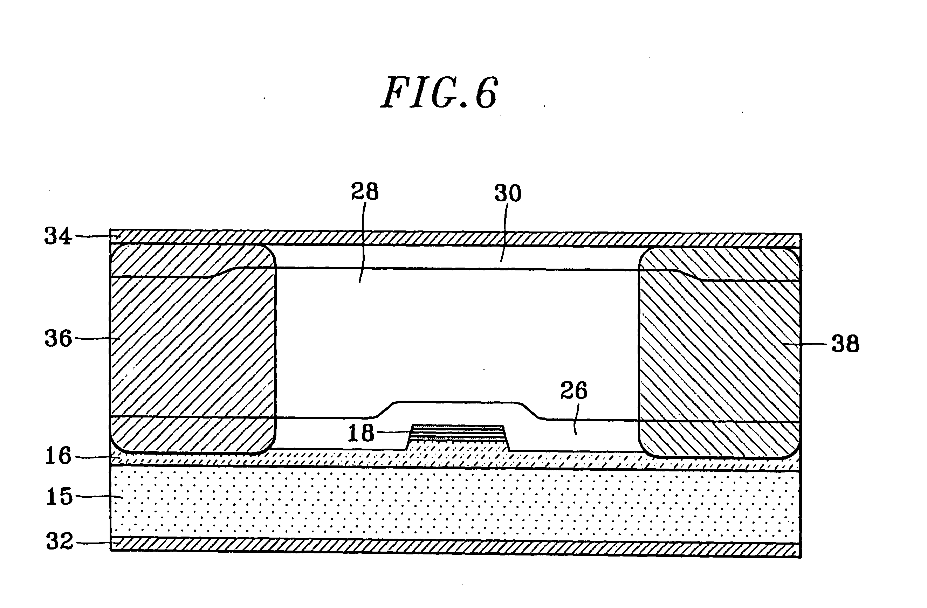

La figure 6 est une vue en coupe transversale schématique d'un dispositif conforme à l'invention qui constitue un laser semiconducteur à ruban enterré de type Fabry-Perot.

Le ruban enterré est le coeur du laser et a une structure de multipuits quantiques à contraintes compensées.

Dans cette structure à multipuits quantiques, les couches de puits constituent les couches de fort indice de réfraction et les couches de barrière constituent les couches de faible indice de réfraction qui permettent la production, par le laser, d'un faisceau lumineux de faible divergence, de longueur d'onde 1,3 µm.

Au sujet des lasers semiconducteurs à ruban enterré, on consultera le document (11).

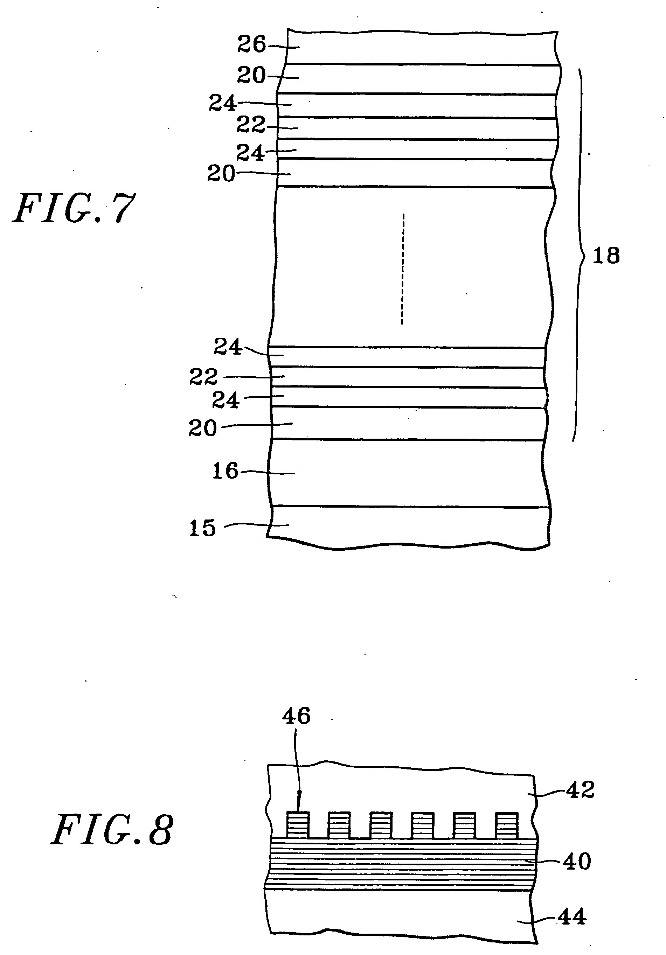

La figure 7 est une vue en coupe transversale schématique agrandie du coeur du laser de la figure 6.

Le laser des figures 6 et 7 comprend un substrat 15 en InP de type n avec un dopage égal à 2x10¹⁸ cm⁻³.

Il comprend aussi, sur le substrat 15, une couche de confinement 16 en InP dopé Si, ce dopage de type n étant égal à 2x10¹⁸ cm⁻³.

L'épaisseur de la couche 16 est environ égale à 1 µm.

Le laser de la figure 6 comprend aussi, sur la couche 16, un ruban 18 comprenant un empilement de dix périodes puits/barrières.

Comme on le voit sur la figure 7, les couches de barrières portent la référence 20 et les couches de puits portent la référence 22.

La couche 16 est en contact avec une couche de barrière 20.

La dernière couche de puits (la plus éloignée de la couche 16) est surmontée par une couche de barrière supplémentaire 20.

Les couches de puits sont en InASP, ont une épaisseur de 7 nm et ont une contrainte en compression de 1,7 %.

Les couches de barrières sont en InGaP, ont une épaisseur de 5 nm et ont une contrainte en tension de 1,5 %.

De plus, dans le cas particulier d'une croissance des couches par OMCVD le ruban 18 comprend des couches 24 en InP de très faible épaisseur (1 à 2 monocouches) comme on le voit sur la figure 7.

Ces couches 24 sont intercalées entre les couches de puits et les couches de barrières.

Le ruban 18 est enterré dans une autre couche de confinement 26 en InP dopé Zn, ce dopage de type p étant égal à 7x10¹⁷ cm⁻³.

L'épaisseur de la couche 26 est environ égale à 0,3 µm.

Cette couche 26 est elle-même surmontée d'une couche épaisse 28 en InP dopé Zn, ce dopage de type p étant égal à 2x10¹⁸ cm⁻³.

L'épaisseur de la couche 28 est environ égale à 3 µm.

Le laser de la figure 6 comprend aussi une couche de contact 30 qui recouvre la couche 28 et qui est en InGaAs dopé Zn, ce dopage de type p étant égal à 3x10¹⁹ cm⁻³.

L'épaisseur de la couche 30 est environ égale à 0,3 µm.

Le laser de la figure 6 comprend aussi une couche de métallisation 32 en Ti/Pt/Au, qui recouvre la face du substrat 15 opposée à celle sur laquelle se trouve la couche 16.

De même, la couche de contact 30 est recouverte par une autre couche de métallisation 34 en Pt/Au.

Des zones d'implantation de protons 36 et 38 sont également prévues de part et d'autre du ruban 18, comme on le voit sur la figure 6.

On explique maintenant un procédé de fabrication du dispositif de la figure 6.

Sur le substrat 15, on forme d'abord la couche 16 puis on réalise par OMCVD (ou par tout autre procédé de croissance comme l'épitaxie par jet moléculaire à source gazeuse ("*gas source molecular beam epitaxy*"), ou GSMBE, ou par épitaxie par jet chimique ("*chemical beam* epitaxy") ou CBE) la structure verticale constituée par l'empilement des couches de puits et des couches de barrières 20 et 22, entre lesquelles on intercale les fines couches 24 dans le cas de l'utilisation de la méthode OMCVD.

La présence de ces couches 24 est très souhaitable dans ce cas.

En effet, malgré la compensation des contraintes, l'empilement des couches 20 et 22 à fortes contraintes provoque une ondulation des épaisseurs des couches suivant une direction perpendiculaire à la direction de croissance.

Cette ondulation s'amplifie avec le nombre de puits et conduit à une dégradation du matériau.

Pour remédier à cet inconvénient, la croissance des matériaux est réalisée à basse température (autour de 600°C) et on ajoute les couches 24 entre les couches de puits et les couches de barrières.

Ensuite, à travers un masque de résine photosensible ou de nitrure de silicium, on définit, par photolithographie, le ruban 18 de largeur 2,8 µm.

Cette largeur du ruban est optimisée pour la structure donnée des couches, de telle façon que cette structure permette un guidage monomode avec un faible indice de réfraction effectif.

Ensuite, on grave le semiconducteur jusqu'à la couche inférieure 16 à travers le masque précédemment formé.

Cette gravure est préférentiellement réalisée par voie sèche (RIBE ou RIE) mais peut aussi être réalisée par voie humide.

Ensuite, après enlèvement total du masque et nettoyage de la structure obtenue, on dépose successivement les couches 26 et 28 pour enterrer le ruban formé puis on dépose la couche de contact 30 fortement dopée.

L'épaisseur de la couche 28 (au moins 2 µm) est importante pour éviter que le mode guidé et dilaté du laser n'atteigne la couche très absorbante 30.

On procède ensuite à la réalisation d'un contact ohmique du côté "p" du laser, par dépôt d'une couche en Pt de 150 nm d'épaisseur suivi par un recuit à 420°C.

On réalise ensuite l'implantation ionique de protons de part et d'autre du ruban actif 18 à travers un masque de résine photosensible de 6 µm de largeur.

Après amincissement du substrat 15, on procède au dépôt de la multicouche de Ti/Pt sur la face-arrière du substrat puis on dépose une couche d'or des deux côtés "p" et "n" du laser et l'on clive les faces de celui-ci.

Les auteurs de la présente invention ont vérifié expérimentalement les performances d'un tel laser.

Celui-ci, long de 400 µm, a un courant de seuil de l'ordre de 15 à 20 mA.

La puissance de sortie en continu excède :
- 60 mW par face avec deux faces clivées et
- 110 mW avec une face clivée et une face à haute réflectivité (95%).

Un fonctionnement laser en courant continu, à une température de 100°C, avec une puissance émise dépassant 10 mW, a été également observé sur ce laser.

La divergence du faisceau, mesurée à mi-hauteur, est
- inférieure à 10° dans la direction parallèle au plan de la jonction p-n du laser et
- inférieure à 20° dans la direction perpendiculaire à ce plan.

Le taux de couplage à une fibre optique clivée est inférieur à 4,5 dB et les tolérances d'alignement sont de +/- 2,2 µm latéralement et de +/- 1,9 µm verticalement.

La figure 8 illustre de façon schématique et partielle un autre dispositif conforme à l'invention qui constitue un laser à contre-réaction distribuée.

On voit sur la figure 8 le coeur 40 de ce laser.

On voit également des couches de confinement 42 et 44 entre lesquelles se trouve le coeur 40.

Conformément à l'invention, ce coeur 40 a une structure de multipuits quantiques avec par exemple quinze périodes de puits et de barrières.

Les couches de puits constituent les couches d'indice de réfraction élevé et les couches de barrières constituent les couches d'indice de réfraction faible permettant l'obtention d'un faisceau lumineux de faible divergence.

De plus, le laser comprend un réseau de diffraction 46 qui se trouve au-dessus du coeur 40.

Ce réseau 46 est obtenu par gravure de l'ensemble des couches de puits et de barrières sur une profondeur correspondant par exemple à 5 de ces couches.

On obtient alors un couplage complexe ("*complex coupling*")*.*

Dans un mode de réalisation non représenté, le réseau de diffraction est gravé dans une couche semiconductrice comprise entre la couche de confinement 42 et la zone active à multipuits quantiques, pour obtenir un couplage par l'indice ("*index coupling*")*.*

Les documents cités dans la présente description sont les suivants :
(1) R. Zengerle, H. Brückner, H. Olzhausen et A. Kohl, "Low-loss fibre-chip coupling by buried laterally tapered InP/InGaAsP waveguide structure, Electronics Letters, 26 Mars 1992, vol. 28, n°6; pp 631-632
(2) B. Mersali, H.J. Brücker, M. Feuillage, S. Sainson, A. Ougazzaden et A. Carenco, "Theoretical and experimental studies of spot-size transformer with integrated waveguide for polarization insensitive optical amplifiers", Journal of Lightwave Technology, vol.13, n°9, Septembre 1995, pp 1865-1872
(3) I.F. Lealman, L.J. Rivers, M.J. Harlow et S.D. Perrin, "InGaAsP/InP tapered active layer multiquantum well laser with 1.8 dB coupling loss to cleaved singlemode fibre", Electronics Letters, 29 Septembre 1994, vol.30, n°20, pp 1685-1687
(4) R. Ben-Michael, U. Koren, B.I. Miller, G. Young, M. Chien et G. Raybon, "InP-based multiple quantum well lasers with an integrated tapered beam expander waveguide", IEEE photonics technology Letters, vol.6, n°12, Décembre 1994, pp 1412-1414
(5) A. Kasukawa, N. Iwai, N. Yamanaka et N. Yokouchi", Output beam characteristics of 1.3 µm GaInAsP/InP SL-QW lasers with narrow and circular output beam, Electronics Letters, 30 Mars 1995, vol.31, n°7, pp 559-560
(6) H. Fukano, Y. Kadota, Y. Kondo, M. Ueki, Y. Sakai, K. Kasaya, K. Yokoyama et Y. Tohmori", 1.3 µm large spot-size laser diodes laterally tapered active layer", Electronics Letters, 17 Août 1995, vol.31, n°17, pp 1439-1440
(7) P. Doussière, P. Garadèbian, C. Graver, E. Derouin, E. Gaumont-Goarin, G. Michaud et R. Meuilleur, "Tapered active stripe for 1.5 µm InGaAsP/InP strained multiple quantum well lasers with reduced beam divergence", Appl. Phys. Lett., 64 (5), 31 janvier 1994, pp 539-541
(8) I. Moerman, M.D'Hondt, W. Vanderbauwhede, P. Van Daele, P. Demeester et W. Hunziker, "InGaAsP/InP strained MQW laser with integrated mode size converter using the shadow masked growth technique", Electronics Letters, 16 Mars 1995, Vol.31, n°6, pp 452-454
(9) Y. Tohmori, Y. Suzaki, H. Oohashi, Y. Sakai, Y. Kondo, H. Okamoto, M. Okamoto, Y. Kadota, O.Mitomi, Y. Itaya et T. Sugie, "High temperature operation with low-loss coupling to fibre for narrow-beam 1.3 µm lasers with butt-jointed selective grown spot-size converter, Electronics Letters, 12 octobre 1995, vol.31, n°21, pp 1838-1840
(10) H. Fukano, K. Yokoyama, Y. Kadota, Y. Kondo, M. Ueki et J. Yoshida, "Low cost, high coupling-efficient and good temperature characteristics 1.3 µm laser diodes spot-size transformer", Proc. 21st Eur. Conf. On Opt. Comm. (ECOC" 95-Brussels)
(11) FR-A-2 673 330, N. Bouadma, "Procédé de réalisation d'un laser à semiconducteur à ruban enterré, utilisant une gravure sèche pour former ce ruban et laser obtenu par ce procédé", Demande de brevet français n°91 02272 du 26 février 1991, voir aussi EP-A-0 501 862 et US-A-5,304,283 ainsi que N. Bouadma et al. "Over 245 mW 1.3 µm buried ridge stripe laser diodes on n-substrate fabricated by the reactive ion beam etching technique", Appl. Phys. Lett., vol.59, n°1, 1 juillet 1991, pp 22-24
(12) A. Ougazzaden, A. Mircea et C. Kazmierski, "High temperature characteristics To and low threshold current density of 1.3 µm InAsP/InGaP/InP compensated strain multiquantum well structure lasers", Electronics Letters, 11 mai 1995, vol.31, n°10, pp 803-804.

## Revendications

1. Dispositif optique à guide de lumière semiconducteur, ce dispositif étant apte à fournir un faisceau lumineux de faible divergence, le guide de lumière comprenant un coeur et des couches de confinement (4, 6; 16, 26; 42, 44) entre lesquelles se trouve le coeur, ce dispositif étant **caractérisé en ce que** le coeur du guide comprend un ensemble de couches semiconductrices comportant une alternance,
- d'au moins une première couche semiconductrice (8; 20) dont l'indice de réfraction est supérieur à l'indice de réfraction de chacune des couches de confinement, et
- d'au moins une deuxième couche semiconductrice (10; 22) dont l'indice de réfraction est inférieur ou supérieur de moins de 5% à l'indice de réfraction de chacune des couches de confinement, l'indice de réfraction équivatent (Ne) du coeur étant superieur à l'indice de réfraction de chacune des couches de confinement.

2. Dispositif selon la revendication 1,
**caractérisé en ce qu'**il comprend une pluralité de premières couches semiconductrices (8; 20) et une pluralité de deuxièmes couches semiconductrices (10; 22) qui alternent avec les premières couches semiconductrices.

3. Dispositif selon l'une quelconque des revendications 1 et 2, **caractérisé en ce que** le coeur du guide comprend en outre des troisièmes couches semiconductrices (12; 14) dont l'indice de réfraction est inférieur à l'indice de réfraction de chaque première couche semiconductrice et supérieur à l'indice de réfraction de chaque deuxième couche semiconductrice.

4. Dispositif selon la revendication 3,
**caractérisé en ce que** le coeur du guide comprend deux troisièmes couches semiconductrices (12) qui sont placées de part et d'autre dudit ensemble de couches.

5. Dispositif selon la revendication 3,
**caractérisé en ce que** le coeur du guide comprend une pluralité de troisièmes couches semiconductrices (14), chaque troisième couche semiconductrice étant comprise entre une première couche semiconductrice (8) et une deuxième couche semiconductrice (10).

6. Dispositif selon l'une quelconque des revendications 1 à 5, **caractérisé en ce que** le nombre de premières couches semiconductrices (8) est ajusté en fonction de la caractéristique modale souhaitée pour le dispositif et **en ce que** le nombre de deuxièmes couches semiconductrices (10) est choisi de façon à obtenir un faible indice de réfraction moyen pour le coeur du guide.

7. Dispositif selon l'une quelconque des revendications 1 à 6, **caractérisé en ce que** le coeur du guide est optiquement inactif.

8. Dispositif selon l'une quelconque des revendications 1 à 6, **caractérisé en ce que** le coeur (18; 40) du guide est optiquement actif.

9. Dispositif selon la revendication 8,
**caractérisé en ce que** le coeur (18; 40) du guide a une structure de multipuits quantiques à contraintes compensées et comprend des couches de puits (20) contraintes, qui sont choisies pour constituer lesdites premières couches semiconductrices, et des couches de barrières (22) contraintes, qui sont choisies pour constituer lesdites deuxièmes couches semiconductrices et sont aptes à compenser les contraintes des couches de puits.

10. Dispositif laser de Fabry-Pérot selon l'une quelconque des revendications 8 et 9, ce dispositif comprenant une zone active, **caractérisé en ce que** cette zone active est constituée par ledit coeur (18) du guide.

11. Dispositif laser à contre-réaction distribuée selon l'une quelconque des revendications 8 et 9, ce dispositif comprenant une zone active munie d'un réseau de diffraction de Bragg, **caractérisé en ce que** la zone active est constituée par ledit coeur (40) du guide.

## Claims

1. An optical device having a semiconductor light guide, the device being capable of providing a low divergence light beam, with the light guide comprising a core and confining layers (4, 6; 16, 26; 42, 44) having the core located therebetween, the device being **characterized in that** the core of the guide is an arrangement of semiconductor layers comprising an alternate arrangement of:
- at least one first semiconductor layer (8; 20), the refractive index of which is higher than the refractive index of each of the confining layers, and
- at least one second semiconductor layer (10; 22), the refractive index of which is lower or higher by less than 5 % than the refractive index of each of the confining layers, with the equivalent refractive index (Ne) of the core being higher than the refractive index of each of the confining layers.

2. The device according to claim 1, **characterized in that** it comprises a plurality of first semiconductor layers (8; 20) and a plurality of second semiconductor layers (10; 22) alternating with the first semiconductor layers.

3. The device according to any of claims 1 and 2, **characterized in that** the core of the guide further comprises third semiconductor layers (12; 14), the refractive index of which is lower than the refractive index of each first semiconductor layer and higher than the refractive index of each second semiconductor layer.

4. The device according to claim 3, **characterized in that** the core of the guide comprises two third semiconductor layers (12), which are placed on either side of said layer arrangement.

5. The device according to claim 3, **characterized in that** the core of the guide comprises a plurality of third semiconductor layers (14), with each third semiconductor layer being included between a first semiconductor layer (8) and a second semiconductor layer (10).

6. The device according to any of claims 1 to 5,
**characterized in that** the number of first semiconductor layers (8) is adapted depending on the desired mode characteristic for the device, and **in that** the number of second semiconductor layers (10) is selected so as to obtain a low average refractive index for the core of the guide.

7. The device according to any of claims 1 to 6,
**characterized in that** the core of the guide is optically inactive.

8. The device according to any of claims 1 to 6,
**characterized in that** the core (18; 40) of the guide is optically active.

9. The device according to claim 8, **characterized in that** the core (18; 40) of the guide has a strain-compensated multiple quantum well structure and comprises strained well layers (20), which are selected to form said first semiconductor layers, and strained barrier layers (22), which are selected to form said second semiconductor layers and are capable of compensating strains of the well layers.

10. The Fabry-Perot laser device according to any of claims 8 and 9, with the device comprising an active zone, **characterized in that** this active zone is composed of said core (18) of the guide.

11. A distributed feedback laser device according to any of claims 8 and 9, comprising an active zone provided with a Bragg diffraction grating, **characterized in that** the active zone is composed of said core (40) of the guide.

## Patentansprüche

1. Optische Vorrichtung mit Halbleiter-Lichtwellenleiter, wobei diese Vorrichtung in der Lage ist, einen Lichtstrahl mit geringer Divergenz bereitzustellen, wobei der Lichtwellenleiter einen Kern und Begrenzungsschichten (4, 6; 16, 26; 42, 44), zwischen denen sich der Kern befindet, umfasst, wobei diese Vorrichtung **dadurch gekennzeichnet ist, dass** der Kern des Wellenleiters eine Anordnung von Halbleiterschichten umfasst, die abwechselnd folgendes umfasst:
- mindestens eine erste Halbleiterschicht (8; 20), deren Brechungsindex größer ist als der Brechungsindex jeder der Begrenzungsschichten, und
- mindestens eine zweite Halbleiterschicht (10; 22), deren Brechungsindex um weniger als 5 % kleiner oder größer ist als der Brechungsindex jeder der Begrenzungsschichten, wobei der äquivalente Brechungsindex (Ne) des Kerns größer ist als der Brechungsindex jeder der Begrenzungsschichten.

2. Vorrichtung nach Anspruch 1, **dadurch gekennzeichnet, dass** sie eine Vielzahl von ersten Halbleiterschichten (8; 20) und eine Vielzahl von zweiten Halbleiterschichten (10; 22), die mit den ersten Halbleiterschichten abwechseln, umfasst.

3. Vorrichtung nach einem der Ansprüche 1 und 2,
**dadurch gekennzeichnet, dass** der Kern des Wellenleiters ferner dritte Halbleiterschichten (12; 14) umfasst, deren Brechungsindex kleiner ist als der Brechungsindex jeder ersten Halbleiterschicht und größer ist als der Brechungsindex jeder zweiten Halbleiterschicht.

4. Vorrichtung nach Anspruch 3, **dadurch gekennzeichnet, dass** der Kern des Wellenleiters zwei dritte Halbleiterschichten (12) umfasst, die auf beiden Seiten der Schichtanordnung angeordnet sind.

5. Vorrichtung nach Anspruch 3, **dadurch gekennzeichnet, dass** der Kern des Wellenleiters eine Vielzahl von dritten Halbleiterschichten (14) umfasst, wobei jede dritte Halbleiterschicht zwischen einer ersten Halbleiterschicht (8) und einer zweiten Halbleiterschicht (10) enthalten ist.

6. Vorrichtung nach einem der Ansprüche 1 bis 5,
**dadurch gekennzeichnet, dass** die Anzahl von ersten Halbleiterschichten (8) je nach der erwünschten modalen Eigenschaft für die Vorrichtung angepasst ist, und dass die Anzahl von zweiten Halbleiterschichten (10) derart gewählt wird, dass ein geringer mittlerer Brechungsindex für den Kern des Wellenleiters erzielt wird.

7. Vorrichtung nach einem der Ansprüche 1 bis 6,
**dadurch gekennzeichnet, dass** der Kern des Wellenleiters optisch inaktiv ist.

8. Vorrichtung nach einem der Ansprüche 1 bis 6,
**dadurch gekennzeichnet, dass** der Kern (18; 40) des Wellenleiters optisch aktiv ist.

9. Vorrichtung nach Anspruch 8, **dadurch gekennzeichnet, dass** der Kern (18; 40) des Wellenleiters eine spannungskompensierte Mehrfach-Quantentopfstruktur aufweist und verspannte Topfschichten (20), die gewählt werden, um die ersten Halbleiterschichten zu bilden, und verspannte Sperrschichten (22), die gewählt werden, um die zweiten Halbleiterschichten zu bilden und in der Lage sind, die Spannungen der Topfschichten zu kompensieren, umfasst.

10. Fabry-Perot-Laservorrichtung nach einem der Ansprüche 8 und 9, wobei diese Vorrichtung eine aktive Zone umfasst, **dadurch gekennzeichnet, dass** diese aktive Zone aus dem Kern (18) des Wellenleiters besteht.

11. Verteilte Rückkopplungs-Laservorrichtung nach einem der Ansprüche 8 und 9, umfassend eine aktive Zone, die mit einem Bragg-Beugungsgitter versehen ist, **dadurch gekennzeichnet, dass** die aktive Zone aus dem Kern (40) des Wellenleiters besteht.
